# FASCICULE DE BREVET EUROPEEN

(11) **EP 4 128 328 B1**
(45) Date de publication et mention de la délivrance du brevet: **03.04.2024**
(21) Numéro de dépôt: 21704867.7
(22) Date de dépôt: 12.01.2021
(51) Int. Cl.: H01L 21/762, H01L 21/02

(54) **PROCEDE DE FABRICATION D'UNE STRUCTURE COMPOSITE COMPRENANT UNE COUCHE MINCE EN SIC MONOCRISTALLIN SUR UN SUBSTRAT SUPPORT EN SIC**
VERFAHREN ZUR HERSTELLUNG EINER VERBUNDSTRUKTUR MIT EINER DÜNNEN SCHICHT AUS MONOKRISTALLINEM SIC AUF EINEM TRÄGERSUBSTRAT AUS SIC
METHOD FOR MANUFACTURING A COMPOSITE STRUCTURE COMPRISING A THIN LAYER MADE OF MONOCRYSTALLINE SIC ON A CARRIER SUBSTRATE MADE OF SIC

(30) Priorité: 27.03.2020 FR 2003024
(43) Date de publication de la demande: 08.02.2023
(73) Titulaire: SOITEC, 38190 Bernin (FR)
(72) Inventeur: BIARD, Hugo, 38100 GRENOBLE (FR)
(74) Mandataire: IP Trust
(86) Numéro de dépôt international: PCT/FR2021/050046
(87) Numéro de publication internationale: WO 2021/191511

(56) Documents cités:
- EP-A1- 1 484 794
- DE-A1-102014 103 518
- FR-A1- 3 000 109
- FR-B1- 2 857 982
- JP-A- 2000 164 600
- JP-A- 2007 273 524
- US-A1- 2012 235 283
- US-A1- 2018 251 910
- RACK M ET AL: "Low-Loss Si-Substrates Enhanced Using Buried PN Junctions for RF Applications", IEEE ELECTRON DEVICE LETTERS, IEEE, USA, vol. 40, no. 5, 1 May 2019 (2019-05-01), pages 690-693, XP011721119, ISSN: 0741-3106, DOI: 10.1109/LED.2019.2908259 [retrieved on 2019-04-24]
- BARAKEL D ET AL: "n-p Junction formation in p-type silicon by hydrogen ion implantation", SOLAR ENERGY MATERIALS AND SOLAR CELLS, ELSEVIER SCIENCE PUBLISHERS, AMSTERDAM, NL, vol. 72, no. 1-4, 1 April 2002 (2002-04-01), pages 285-290, XP004339776, ISSN: 0927-0248, DOI: 10.1016/S0927-0248(01)00176-3

## Description

### DOMAINE DE L'INVENTION

La présente invention concerne le domaine des matériaux semiconducteurs pour composants microélectroniques. Elle concerne en particulier un procédé de fabrication d'une structure composite comprenant une couche mince en carbure de silicium monocristallin sur un substrat support en carbure de silicium.

### ARRIERE PLAN TECHNOLOGIQUE DE L'INVENTION

L'intérêt pour le carbure de silicium (SiC) a considérablement augmenté au cours des dernières années, car ce matériau semiconducteur peut accroître la capacité de traitement de l'énergie. Le SiC est de plus en plus largement utilisé pour la fabrication de dispositifs de puissance innovants, pour répondre aux besoins de domaines montants de l'électronique, comme notamment les véhicules électriques.

Les dispositifs de puissance et les systèmes intégrés d'alimentation basés sur du carbure de silicium monocristallin peuvent gérer une densité de puissance beaucoup plus élevée par rapport à leurs homologues traditionnels en silicium, et ce avec des dimensions de zone active inférieures. Pour limiter encore les dimensions des dispositifs de puissance sur SiC, il est avantageux de fabriquer des composants verticaux plutôt que latéraux. Pour cela, une conduction électrique verticale, entre une électrode disposée en face avant de la structure SiC et une électrode disposée en face arrière, doit être autorisée par ladite structure.

Les substrats en SiC monocristallin destinés à l'industrie microélectronique restent néanmoins chers et difficiles à approvisionner en grande taille. Il est donc avantageux de recourir à des solutions de transfert de couches minces, pour élaborer des structures composites comprenant typiquement une couche mince en SiC monocristallin sur un substrat support plus bas coût. Une solution de transfert de couche mince bien connu est le procédé Smart Cut^{™}, basé sur une implantation d'ions légers et sur un assemblage par collage direct. Un tel procédé permet par exemple de fabriquer une structure composite comprenant une couche mince en SiC monocristallin (c-SiC), prélevée d'un substrat donneur en c-SiC, en contact direct avec un substrat support en SiC poly-cristallin (p-SiC), et autorisant une conduction électrique verticale. Il reste néanmoins difficile de réaliser un collage direct par adhésion moléculaire de bonne qualité entre deux substrats c-SiC et p-SiC, car la gestion de la rugosité et de l'état de surface desdits substrats est complexe.

Différentes méthodes dérivées de ce procédé sont également connues de l'état de la technique. Par exemple, F.Mu et al (ECS Transactions, 86 (5) 3-21, 2018) mettent en oeuvre un collage direct, après activation des surfaces à assembler par bombardement d'argon (SAB pour « Surface Activation bonding ») : un tel traitement préalable au collage génère une très forte densité de liaisons pendantes, lesquelles favorisent la formation de liaisons covalentes à l'interface d'assemblage, et donc une forte énergie de collage. Cette méthode présente néanmoins l'inconvénient de générer une couche amorphe, à la surface du substrat donneur en SiC monocristallin, qui impacte défavorablement la conduction électrique verticale entre la couche mince en c-SiC et le substrat support en p-SiC.

Des solutions ont été proposées pour résoudre ce problème, en particulier dans le document EP3168862, mettant en oeuvre une implantation d'espèces dopantes dans ladite couche amorphe, pour restaurer ses propriétés électriques. L'inconvénient principal de cette approche est sa complexité et donc son coût.

On connaît par ailleurs le document US8436363, qui décrit un procédé de fabrication d'une structure composite comprenant une couche mince en c-SiC disposée sur un substrat support métallique dont le coefficient de dilatation thermique est apparié avec celui de la couche mince. Ce procédé de fabrication comprend les étapes suivantes :
- la formation d'un plan fragile enterré dans un substrat donneur de c-SiC, délimitant une couche mince entre ledit plan fragile enterré et une surface avant du substrat donneur,
- le dépôt d'une couche métallique, par exemple en tungstène ou en molybdène, sur la surface avant du substrat donneur pour former le substrat support d'une épaisseur suffisante pour remplir le rôle de raidisseur,
- la séparation le long du plan fragile enterré, pour former d'une part, la structure composite comprenant le substrat support métallique et la couche mince en c-SiC, et d'autre part, le reste du substrat donneur en c-SiC.

Un tel procédé de fabrication n'est cependant pas compatible lorsque le matériau formant le substrat support est du p-SiC requérant un dépôt à des températures supérieures à 1200°C (températures habituelles pour la fabrication de p-SiC). En effet, à ces températures élevées, la cinétique de croissance des cavités présentes dans le plan fragile enterré est plus rapide que la cinétique de croissance de la couche en p-SiC et l'épaisseur requise pour un effet raidisseur n'est pas atteinte avant l'apparition du phénomène de cloquage, lié à la déformation de la couche à l'aplomb des cavités.

D'autres documents de l'art antérieur décrivant différentes méthodes d'obtention de substrats composites peuvent être consultés dans le document EP1484794 A1, US2018/251910 A1, JP2007273524 A et FR3000109 A1.

Quelle que soit la technique de transfert de couche utilisée, se pose en outre le problème de fournir une structure composite comprenant une couche mince en c-SiC de très haute qualité, et en particulier dépourvue de défauts étendus (ou en présentant une très faible densité), susceptibles d'affecter les performances et la fiabilité des dispositifs de puissance destinés à être élaborés sur ladite couche mince.

### OBJET DE L'INVENTION

La présente invention concerne une solution alternative à celles de l'état de la technique, et vise à remédier à tout ou partie des inconvénients précités. Elle concerne en particulier un procédé de fabrication d'une structure composite comprenant une couche mince en c-SiC de haute qualité disposée sur un substrat support en SiC de moindre qualité.

### BREVE DESCRIPTION DE L'INVENTION

L'invention concerne un procédé de fabrication d'une structure composite comprenant une couche mince en carbure de silicium monocristallin disposée sur un substrat support en carbure de silicium. Le procédé comprend les étapes suivantes :
a) une étape de fourniture d'un substrat donneur en carbure de silicium monocristallin,
b) une étape d'implantation ionique d'espèces légères dans le substrat donneur, pour former un plan fragile enterré délimitant la couche mince entre ledit plan fragile enterré et une surface libre dudit substrat donneur,
c) une succession de n étapes de formation de couches supports cristallisées, avec n supérieur ou égal à 2 ; les n couches supports cristallisées étant disposées sur la face avant du substrat donneur successivement les unes sur les autres, et formant le substrat support ; chaque étape de formation comprenant :
   - un dépôt chimique en phase vapeur assisté par injection liquide directe, à une température inférieure à 900°C, pour former une couche support, ladite couche support étant formée par une matrice SiC au moins partiellement amorphe, et présentant une épaisseur inférieure ou égale à 200 microns ;
   - un traitement thermique de cristallisation de la couche support, à une température inférieure ou égale à 1000°C, pour former une couche support cristallisée,
d) une étape de séparation le long du plan fragile enterré, pour former d'une part une structure composite comprenant la couche mince sur le substrat support, et d'autre part le reste du substrat donneur.

Selon d'autres caractéristiques avantageuses et non limitatives de l'invention, prises seules ou selon toute combinaison techniquement réalisable :
- Le procédé comprend une étape e) de traitement(s) mécanique(s) et/ou chimique(s) de la structure composite, les traitements étant appliqué(s) à une face libre du substrat support, face arrière de la structure composite et/ou à une face libre de la couche mince, face avant de la structure composite ;
- l'étape e) comprend un polissage mécano-chimique simultané de la face avant et de la face arrière de la structure composite ;
- une gravure chimique, un rodage mécanique et/ou un polissage mécano-chimique est(sont) appliqué(s) à une face libre du substrat support, entre l'étape c) et l'étape d) ;
- l'épaisseur de chaque couche support déposée est inférieure ou égale à 100 microns, voire inférieure à 50 microns, voire encore inférieure à 10 microns ;
- les dépôts de l'étape c) sont effectués à une température comprise entre 100°C et 800°C, voire préférentiellement entre 200°C et 600°C ;
- les dépôts de l'étape c) sont effectués sous une pression comprise entre 1 Torr et 500 Torr ;
- les précurseurs, utilisés lors les dépôts de l'étape c), sont choisis parmi le polysilyléthylène et le disilabutane ;
- l'étape c) comprend une succession de n étapes de formation de couches support cristallisées, avec n compris entre 3 et quelques dizaines ;
- l'étape a) comprend une étape a') de fourniture d'un substrat initial en carbure de silicium monocristallin, et une étape a") de croissance par épitaxie d'une couche donneuse en carbure de silicium monocristallin sur le substrat initial, pour former le substrat donneur, la couche donneuse présentant une densité de défauts cristallins inférieure à celle du substrat initial ;
- l'étape a') comprend la formation, sur le substrat initial, d'une couche monocristalline de conversion, pour convertir des défauts de type dislocation du plan basal du substrat initial en défauts de type dislocations coin traversantes ;
- l'étape a") de croissance par épitaxie est effectuée à une température supérieure à 1200°C, préférentiellement comprise entre 1500°C et 1650°C ;
- l'étape d) de séparation est opérée à une température supérieure ou égale à la température des traitements thermiques de cristallisation de l'étape c) ;
- le procédé comprend une étape de reconditionnement du reste du substrat donneur en vue d'une réutilisation en tant que substrat initial ou en tant que substrat donneur.

### BREVE DESCRIPTION DES FIGURES

D'autres caractéristiques et avantages de l'invention ressortiront de la description détaillée de l'invention qui va suivre en référence aux figures annexées sur lesquelles :

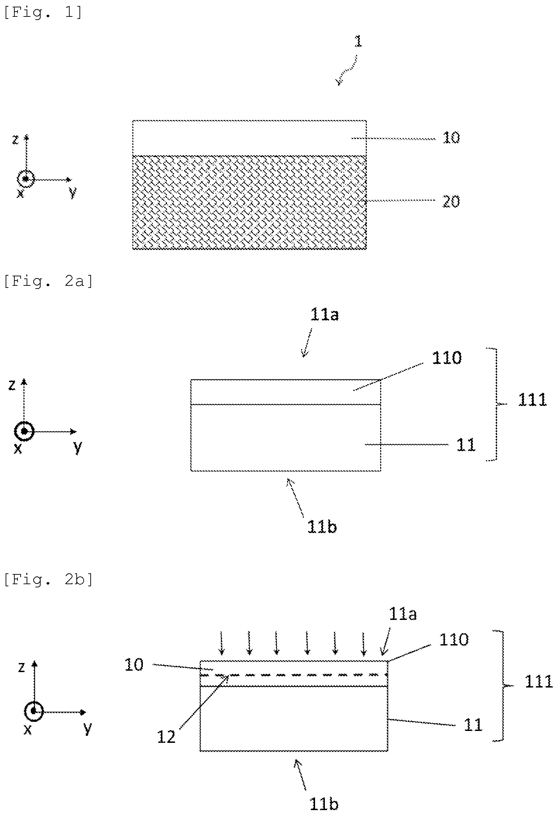

[Fig. 1] La figure 1 présente une structure composite élaborée selon un procédé de fabrication conforme à l'invention ;
[Fig. 2a]
[Fig. 2b]
[Fig. 2c(i)]

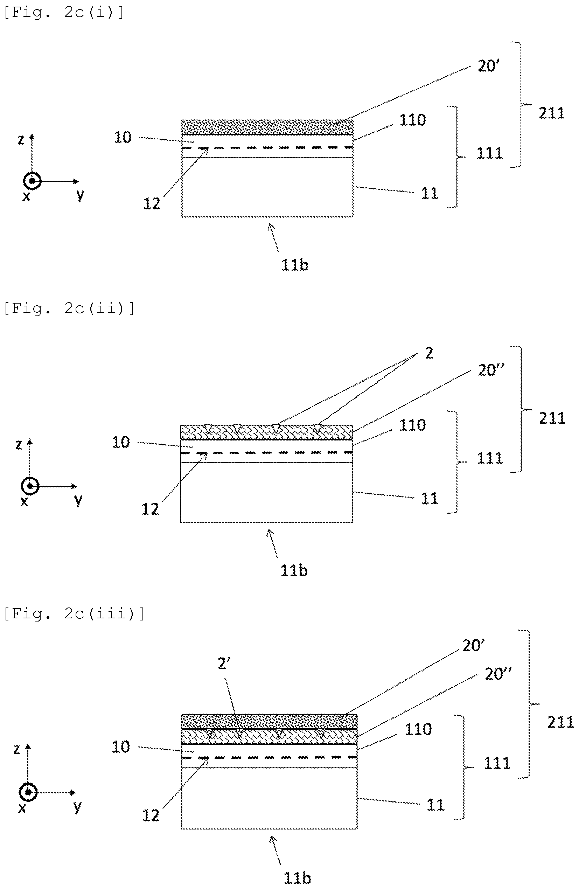

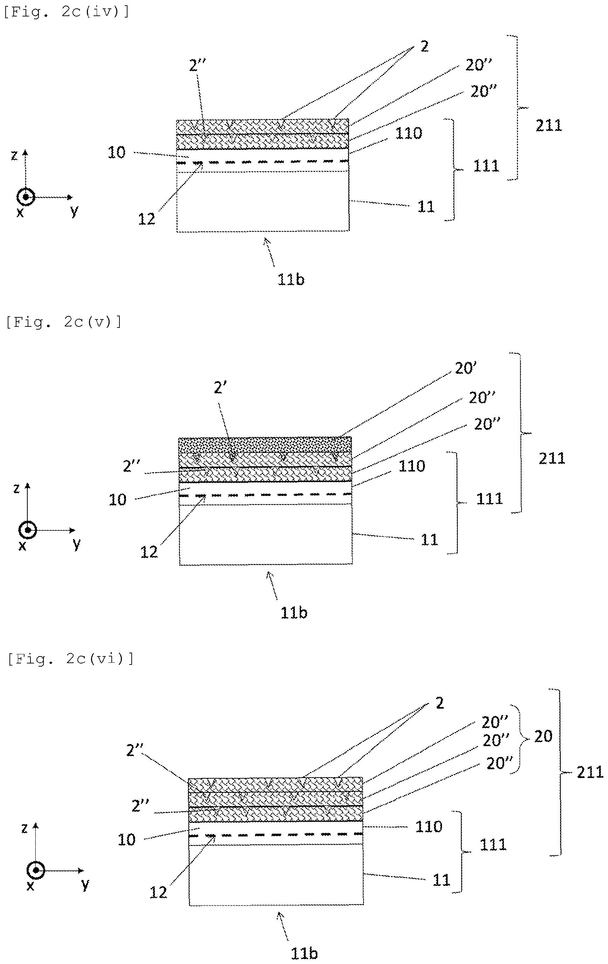

[Fig. 2c(ii)]
[Fig. 2c(iii)]
[Fig. 2c(iv)]
[Fig. 2c(v)]
[Fig. 2c(vi)]
[Fig. 2d]
[Fig. 2e]

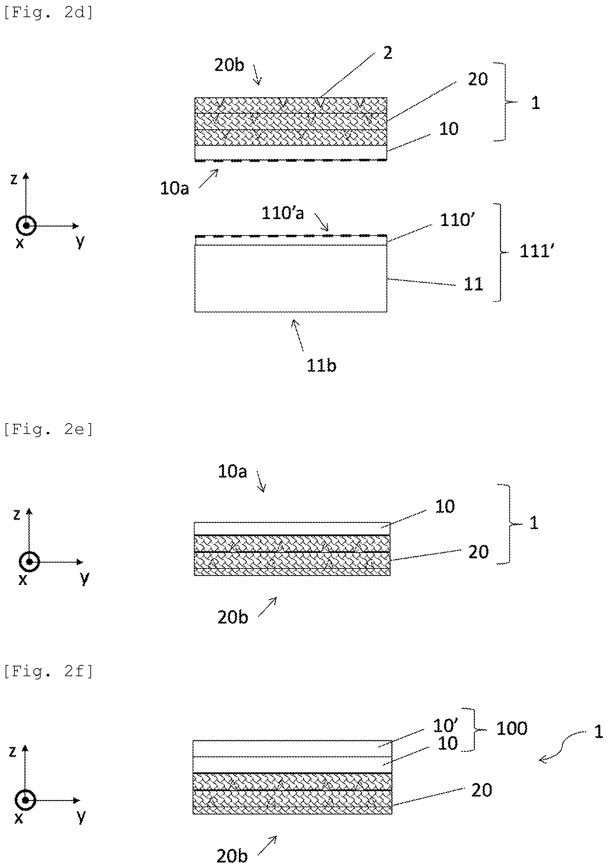

[Fig. 2f] Les figures 2a à 2f présentent des étapes d'un procédé de fabrication conforme à l'invention ;
[Fig. 3a]

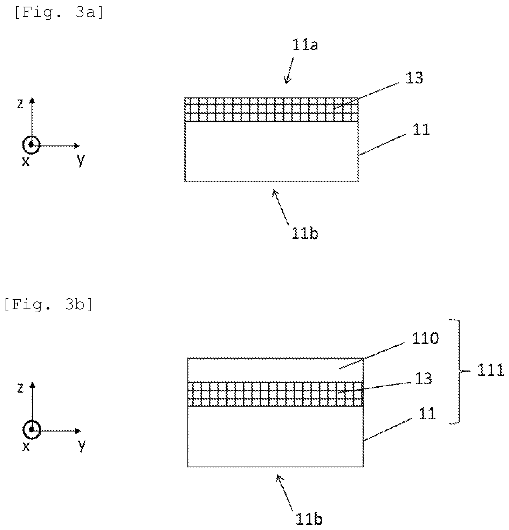

[Fig. 3b] Les figures 3a et 3b présentent des étapes d'un procédé de fabrication conforme à l'invention.

### DESCRIPTION DETAILLEE DE L'INVENTION

Dans la partie descriptive, les mêmes références sur les figures pourront être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas respectées sur les figures.

La présente invention concerne un procédé de fabrication d'une structure composite 1 comprenant une couche mince 10 en carbure de silicium monocristallin disposée sur un substrat support 20 en carbure de silicium (figure 1). Le substrat support 20 est avantageusement poly-cristallin (« p-SiC » sera utilisé pour parler de SiC poly-cristallin).

Le procédé comprend en premier lieu une étape a) de fourniture d'un substrat donneur 111 en carbure de silicium monocristallin. Dans la suite de la description, « c-SiC » sera utilisé pour parler de carbure de silicium monocristallin.

Le substrat donneur 111 se présente préférentiellement sous la forme d'une plaquette de diamètre 100mm, 150mm ou 200mm, voire 300mm ou même 450mm, et d'épaisseur comprise typiquement entre 300 et 800 microns. Il présente une face avant 11a et une face arrière 11b. La rugosité de surface de la face avant 11a est avantageusement choisie inférieure à 1 nm Ra, rugosité moyenne (« average roughness » selon la terminologie anglo-saxonne) mesurée par microscopie à force atomique (AFM) sur un scan de 20 microns x 20 microns.

Selon un mode de réalisation avantageux, l'étape a) comprend une étape a') de fourniture d'un substrat initial 11 en carbure de silicium monocristallin. Elle comprend ensuite une étape a") de croissance par épitaxie d'une couche donneuse 110 en carbure de silicium monocristallin sur le substrat initial 11, pour former le substrat donneur 111 (figure 2a). L'étape de croissance par épitaxie est réalisée de sorte que la couche donneuse 110 présente une densité de défauts cristallins inférieure à celle du substrat initial 11.

Par exemple, le substrat initial 11 en c-SiC peut être de polytype 4H ou 6H, présentant une désorientation ("offcut") inférieure à 4.0° par rapport à l'axe cristallographique <11-20> ± 0.5°, et une densité de dislocations traversantes (« Micropipes ») inférieure ou égale à 5/cm², voire inférieure à 1/cm². Dopé de type N (azote), il présente une résistivité préférentiellement comprise entre 0.015 ohm.cm et 0.030 ohm.cm. Bien sûr, le dopant pourrait être autre que l'azote et le dopage pourrait éventuellement être de type P. On pourra choisir un substrat initial 11 présentant une faible densité de défauts de type dislocation du plan basal ou BPD (pour « basal plane dislocation » selon la terminologie anglo-saxonne), typiquement inférieure ou égale à 3000/cm². Des substrats de c-SiC présentant des densités de BPD de l'ordre de 1500/cm² sont raisonnablement disponibles, ce qui facilite leur approvisionnement.

Il est avantageux que la couche donneuse 110, à partir de laquelle la couche mince 10 en c-SiC de la structure composite 1 sera formée à l'issue du procédé de l'invention, présente une excellente qualité cristalline, pour répondre aux spécifications requises des composants verticaux destinés à être élaborés sur ladite couche mince 10. En effet, différents types de défauts étendus sont présents dans une couche ou un substrat en c-SiC. Ces défauts étendus peuvent affecter les performances et la fiabilité des composants. En particulier, les défauts de type BPD sont tueurs pour des composants bipolaires, car un défaut d'empilement de type Shockley ou SSF (pour « Shockley stacking fault ») est étendu à partir de la dislocation lorsque l'énergie de recombinaison d'une paire électron-trou est disponible. L'expansion d'un défaut d'empilement SSF à l'intérieur de la région active du composant entraîne une augmentation de la résistance à l'état passant du composant.

La couche donneuse 110 en c-SiC est donc élaborée de manière à présenter une densité de défauts de type BPD inférieure ou égale à 1/cm².

Pour cela, l'étape a") de croissance par épitaxie est effectuée à une température supérieure à 1200°C, préférentiellement comprise entre 1500°C et 1650°C. Les précurseurs utilisés sont le silane (SiH4), le propane (C3H8) ou l'éthylène (C2H4) ; le gaz porteur pourra être de l'hydrogène avec ou sans argon.

Le faible taux de défauts BPD dans la couche donneuse 110 est obtenu en privilégiant la conversion des défauts BPD présents dans le substrat initial 11 en dislocations coins traversantes ou TED (pour « Threading Edge Dislocations »).

Selon un mode de réalisation particulier, l'étape a") comprend la formation d'une couche monocristalline de conversion 13, préférentiellement en c-SiC, pour maximiser la conversion des défauts de type BPD du substrat initial 11 en défauts de type TED (figure 3a). Pour cela, il est avantageux de choisir un angle de découpe faible proche de 4° pour le substrat initial 11 en c-SiC, d'augmenter la gravure in situ réalisée avant la croissance épitaxiale, de viser de fortes vitesses de croissance (typiquement supérieures à 5pm/h) et enfin de choisir des conditions de croissance de la couche monocristalline de conversion 13, avec un ratio C/Si au niveau des flux de précurseurs proche de 1.

La croissance épitaxiale de la couche donneuse 110 sur ladite couche de conversion 13 peut ensuite être opérée (figure 3b). Selon ce mode particulier de réalisation, il est également possible d'obtenir une couche donneuse 110 en c-SiC présentant une densité de défauts de type BPD inférieure ou égale à 1/cm² voire inférieure à 0,1/cm². De plus, la probabilité de dégradation bipolaire (probabilité qu'un trou arrive sous le point de conversion BPD/TED) à l'issue du procédé selon la présente invention est négligeable (< 0.1%), la couche monocristalline de conversion 13 n'étant pas destinée à être transférée dans la structure composite 1. L'état de l'art visant à réduire les dégradations bipolaires consiste à intégrer entre la couche de conversion et la couche active, une couche de recombinaison (dopée azote au-delà 1^{E}18 at/cm³). Cette couche peut, au prix d'une épaisseur de 10µm et d'une concentration supérieure à 5^{E}18/cm³, réduire la probabilité de présence des trous à 0,1% par rapport à la structure de base ne comportant pas cette couche de recombinaison. Dans la présente invention, la couche monocristalline de conversion 13 n'étant pas transférée, la probabilité qu'un trou atteigne le point de nucléation de la dégradation bipolaire (point de conversion BPD - TED ou tout point de BPD) est a minima inférieure à 0,1% voire proche de 0%.

Notons que des séquences conventionnelles de nettoyage ou de gravure du substrat initial 11, visant à éliminer tout ou partie de contaminants particulaires, métalliques, organiques, ou une couche d'oxyde natif potentiellement présents sur sa face avant 11a, pourront être réalisées préalablement et/ou postérieurement à l'étape a") de croissance par épitaxie.

Alternativement, le substrat donneur 111 peut être uniquement formé d'un substrat initial 11 présentant une densité de défauts faible, compatible avec les spécifications de la future couche mince 10 ; cette dernière sera alors prélevée du substrat donneur 111 comme décrit ci-dessous dans les étapes suivantes du procédé.

Le procédé de fabrication selon l'invention comprend, en outre, une étape b) d'implantation ionique d'espèces légères dans le substrat donneur 111 (et en particulier dans la couche donneuse 110 lorsque celle-ci est présente), jusqu'à une profondeur déterminée représentative de l'épaisseur de couche mince 10 souhaitée. Notons que la profondeur restera toujours inférieure à l'épaisseur de la couche donneuse 110 lorsqu'elle et présente. Cette implantation génère un plan fragile enterré 12 dans le substrat donneur 111 qui délimite la couche mince 10 entre ledit plan fragile enterré 12 et une surface libre 11a dudit substrat donneur 111 (figure 2b).

Les espèces légères implantées sont préférentiellement de l'hydrogène, de l'hélium ou une co-implantation de ces deux espèces. Comme cela est bien connu en référence au procédé Smart Cut^{™}, ces espèces légères vont former, autour de la profondeur déterminée, des microcavités distribuées dans une fine couche parallèle à la surface libre 11a du substrat donneur 111, soit parallèle au plan (x,y) sur les figures. On appelle cette fine couche le plan fragile enterré 12, par souci de simplification.

L'énergie d'implantation des espèces légères est choisie de manière à atteindre la profondeur déterminée dans le substrat donneur 111.

Typiquement, des ions hydrogène seront implantés à une énergie comprise entre 10 keV et 250 keV, et à une dose comprise entre 5^{E}16/cm2 et 1^{E}17/cm2, pour délimiter une couche mince 10 présentant une épaisseur de l'ordre de 100 à 1500 nm.

Notons qu'une couche de protection pourra être déposée sur la face libre du substrat donneur 111, préalablement à l'étape d'implantation ionique. Cette couche de protection peut être composée par un matériau tel que l'oxyde de silicium ou le nitrure de silicium par exemple.

Le procédé selon l'invention comprend ensuite une succession de n étapes de formation de couches supports cristallisées 20", avec n supérieur ou égal à 2. Le nombre d'étapes successives de formation pourra être supérieur ou égal à 3 ; et, il pourra aller typiquement jusqu'à quelques dizaines.

Les n couches support cristallisées 20" sont disposées sur la face avant 11a du substrat donneur 111 successivement les unes sur les autres ; elles forment le substrat support 20. Dit autrement, une première couche support cristallisée 20" est directement en contact avec la face 11a avant du substrat donneur 111, puis une deuxième couche support cristallisée 20" est en contact avec la première, et ainsi de suite pour le n couches support cristallisées 20" (figures 2c (i) à (vi)).

Chaque étape de formation comprend un dépôt chimique en phase vapeur assisté par injection liquide directe (DLI-CVD, pour « Direct Liquid Injection Chemical Vapor Déposition ») suivi d'un traitement thermique de cristallisation de la couche déposée 20'.

Le dépôt DLI-CVD est effectué à une température inférieure à 900°C et préférentiellement, à une température comprise entre 100°C et 800°C, entre 100°C et 700°C, voire avantageusement entre 200°C et 600°C. La pression dans la chambre de dépôt est définie entre 1 Torr et 500 Torr.

La technique de dépôt DLI-CVD procure de bons rendements entre les matières (précurseurs) apportées et les épaisseurs de dépôt atteintes, sans nécessité d'utiliser des précurseurs chlorés, ce qui limite les coûts et les contraintes environnementales. Préférentiellement, le dépôt DLI-CVD met en oeuvre un précurseur disilanebutane ou un précurseur polysilyléthylène, ledit précurseur étant pur ou dilué. D'autres précurseurs tels que le methyltrichlorosilane, l'ethylenetrichlorosilane, le dichloromethylvinylsilane, le tetraethylsilane, le tetramethylsilane, le diethylmethylsilane, le bistrimethylsilylmethane, l'hexamethyldisilane pourraient éventuellement être utilisés.

La technique de dépôt DLI-CVD est décrite dans la thèse de Guilhaume Boisselier (2013, « Dépôt chimique en phase vapeur de carbures de chrome, de silicium et d'hafnium assisté par injection liquide pulsée »), pour des applications de dépôt de revêtements céramiques sur des pièces, pour les protéger lors de traitements à très hautes températures, par exemple des pièces métalliques en acier ou alliages.

La demanderesse a développé un dépôt DLI-CVD pour une application tout à fait différente, à savoir la formation d'une couche support 20' déposée sur un substrat donneur 111 en c-SiC, pour obtenir, à l'issue du procédé de fabrication, une structure composite 1, destinée au domaine microélectronique.

La couche support 20' déposée forme une matrice SiC comprenant du SiC amorphe, et des sous-produits de réaction issus des précurseurs utilisés lors du dépôt et formés de chaines carbonées. En outre, la matrice SiC peut éventuellement comprendre des grains cristallins de SiC.

En général, la couche support 20' présentera une épaisseur inférieure ou égale à 200 microns, inférieure ou égale à 100 microns, inférieure ou égale à 50 microns, inférieure ou égale à 10 microns, voire inférieure ou égale à quelques microns. Notons que la technique DLI-CVD peut procurer une vitesse de dépôt supérieure ou égale à 10 microns/heure, voire supérieure à 50 microns/heure, voire encore supérieure à 100 microns/heure.

L'épaisseur de chaque couche support 20' déposée peut être identique mais cela n'est pas requis. Selon une option, les épaisseurs des n couches support 20' successivement déposées sont croissantes ; cela peut limiter l'influence néfaste de la différence de coefficients de dilatation thermique des couches en présence dans la structure : des couches supports 20' plus fines déposées au début subissent moins de contraintes dans la structure (notamment lors du traitement thermique de cristallisation suivant le dépôt) que des couches épaisses, et permettent de faire évoluer le coefficient de dilatation thermique vers un coefficient moyen, plus favorable au dépôt subséquent de couches supports 20' plus épaisses.

Selon une autre option, les épaisseurs des n couches support 20' successivement déposées sont décroissantes ; cela procure l'avantage de diminuer progressivement la taille des fissures générées au cours du traitement thermique de cristallisation de la couche déposée 20', traitement qui sera détaillé plus loin dans la description.

Notons que l'étape c) vise avantageusement à définir une interface non-isolante entre le substrat donneur 111 et le substrat support 20. En d'autres termes, l'étape c) est réalisée de sorte que l'interface entre le substrat donneur 111 et le substrat support 20 dans la structure composite finale 1 soit électriquement conductrice : on visera une résistance spécifique de l'interface préférentiellement inférieure à 1 mohm.cm². Avantageusement, pour assurer la conductivité électrique de l'interface, un retrait de l'oxyde natif présent sur la face libre 11a du substrat donneur 111 est réalisé par désoxydation HF (acide fluorhydrique), par voie humide ou sèche. Alternativement, un surdopage au moins des premiers nanomètres déposés de la première couche support 20' pourra être opéré par l'introduction d'espèce dopantes lors du dépôt DLI-CVD. Notons que, de manière générale, des espèces dopantes pourront être introduites (à différents dosages) lors des n dépôts de l'étape c) selon le niveau de dopage et la conductivité électrique visés du substrat support 20.

De manière également avantageuse, préalablement à la désoxydation et/ou à la formation la première couche support 20', des séquences de nettoyage sont appliquées au substrat donneur 111 pour éliminer tout ou partie de contaminants particulaires, métalliques ou organiques potentiellement présents sur ses faces libres.

Après le dépôt DLI-CVD, l'étape c) comprend un traitement thermique de cristallisation de la couche support 20', à une température inférieure ou égale à 1000°C, pour former une couche support cristallisée 20". La température du traitement thermique pourra par exemple être de 950°C ou 900°C ou encore 800°C. L'atmosphère de recuit peut notamment comprendre des gaz tels que l'argon, l'azote, l'hydrogène, l'hélium ou un mélange de ces gaz.

Un tel recuit a pour effet d'éliminer l'hydrogène de la couche support 20' et de provoquer la cristallisation de la matrice SiC sous forme de SiC poly-cristallin.

Un four traditionnel, permettant le traitement d'une pluralité de structures simultanément (recuit en batch) peut être utilisé pour réaliser le traitement thermique de cristallisation. La durée typique du traitement est alors comprise entre quelques minutes et quelques heures.

Le traitement thermique de cristallisation peut alternativement être opéré dans un four de recuit rapide (« RTP » pour « rapid thermal processing » selon la terminologie anglo-saxonne). La durée typique de recuit est comprise entre quelques secondes et quelques minutes.

Enfin, il est également envisageable de réaliser le traitement thermique de cristallisation in situ, dans la chambre de dépôt DLI, pendant une durée typique de l'ordre de quelques minutes.

L'épaisseur relativement faible de la couche support 20' déposée permet une cristallisation rapide, ce qui évite que le budget thermique du traitement thermique de cristallisation provoque une croissance trop importante des cavités dans le plan fragile enterré 12 du substrat donneur 111. Par exemple, pour une couche support 20' de 10 microns d'épaisseur, un traitement thermique de cristallisation à 800°C pendant 10 min peut être appliqué ; un tel budget thermique est insuffisant pour dépasser la taille et densité critique (bullage ou séparation spontanée le long du plan fragile enterré 12) des cavités présentes dans le plan fragile enterré 12 du substrat donneur 111.

Il est important de noter que la cristallisation de chaque couche support 20' provoque souvent des fissures 2 dans la couche support cristallisée 20", ce qui impacte sa qualité mécanique et électrique. C'est la raison pour laquelle le procédé selon l'invention prévoit une succession d'étapes de formation de couche support cristallisées 20".

Comme cela est visible sur la figure 2c(i), une première couche support 20' est déposée sur le substrat donneur 111 lors d'un premier dépôt DLI-CVD. Un premier traitement thermique de cristallisation est ensuite appliqué à l'empilement, ce qui provoque la transformation de la première couche support 20' en première couche support cristallisée 20" sous forme de poly-SiC, et l'apparition de fissures 2 dans ladite couche cristallisée 20" (figure 2c (ii)).

Un deuxième dépôt DLI-CVD est alors réalisé, sur la surface libre de la première couche support cristallisée 20" (figure 2c (iii)) et notamment, dans les fissures 2 : on obtient ainsi une deuxième couche support 20' superficielle ainsi que des fissures remplies 2' du même matériau (matrice SiC au moins partiellement amorphe) que ladite deuxième couche 20'. Un deuxième traitement thermique de cristallisation est appliqué à l'empilement, qui engendre la transformation de la deuxième couche support 20' en deuxième couche support cristallisée 20" sous forme de p-SiC, et l'apparition de fissures 2 dans ladite deuxième couche cristallisée 20" (figure 2c (iv)). La matrice SiC présente dans les fissures 2" de la première couche support cristallisée 20" cristallise également sous forme de p-SiC, ce qui permet de guérir ladite première couche 20" de ses fissures initiales superficielles 2.

Un troisième dépôt DLI-CVD peut être ensuite réalisé, sur la surface libre de la deuxième couche support cristallisée 20" (figure 2c (v)) et notamment, dans les fissures 2 débouchantes : on obtient ainsi une troisième couche support 20' ainsi que des fissures remplies 2' du même matériau que ladite troisième couche 20'. Un troisième traitement thermique de cristallisation est appliqué à l'empilement, qui engendre la transformation de la troisième couche support 20' en troisième couche support cristallisée 20" sous forme de p-SiC, et l'apparition de fissures 2 dans ladite troisième couche cristallisée 20" (figure 2c (vi)). La matrice SiC présente dans les fissures 2" de la deuxième couche support cristallisée 20" cristallise également sous forme de p-SiC, ce qui permet de guérir ladite deuxième couche de ses fissures initiales 2.

Notons que les n dépôts DLI-CVD pourront être réalisés à des températures différentes, ainsi que les n recuits de cristallisation.

Le procédé comporte au moins deux étapes successives de formation de couches supports cristallisées 20". A titre d'exemple, les figures 2c (i) à (vi) en présentent trois, mais il est tout à fait envisageable de réaliser entre 2 et 10, voire quelques dizaines d'étapes successives de dépôt et cristallisation, jusqu'à l'obtention du substrat support 20 formé par la superposition des couches supports cristallisées 20".

Les paramètres de dépôt et de recuit de cristallisation de l'étape c) sont déterminés pour que ledit substrat support 20 présente :
- une bonne conductivité électrique, soit inférieure à 0,03 ohm.cm, voire inférieure à 0,01 ohm.cm,
- une haute conductivité thermique, soit supérieure ou égale à 150 W.m⁻¹.K⁻¹, voire à 200 W.m⁻¹.K⁻¹,
- et un coefficient de dilatation thermique proche de celui de la couche mince 10, soit typiquement entre 3,8^{E}-6 /K et 4,2^{E}-6 /K à température ambiante.

Pour obtenir ces propriétés, on vise préférentiellement pour le substrat support 20 les caractéristiques structurelles suivantes : structure poly-cristalline, grains de type 3C SiC, orientés 111, de taille moyenne 1 à 50pm dans le plan principal du substrat, dopage de type N pour une résistivité finale inférieure ou égale à 0,03 ohm.cm, voire inférieure ou égale à 0,01 ohm.cm.

A l'issue de l'étape c), le substrat support 20 présente une épaisseur suffisante pour opérer l'étape d) suivante de séparation, et avantageusement l'épaisseur souhaitée pour la structure composite 1. L'épaisseur du substrat support 20 pourra ainsi être supérieure ou égale à 10 microns, à 50 microns, voire même supérieure ou égale à 100 microns.

L'empilement 211 résultant de l'étape c) comprend le substrat support 20 disposé sur le substrat donneur 111.

Le procédé selon la présente invention comprend ensuite une étape d) de séparation le long du plan fragile enterré 12, pour former d'une part la structure composite 1 et d'autre part le reste 111' du substrat donneur (figure 2d).

Selon un mode avantageux de mise en oeuvre, l'étape d) de séparation est opérée en appliquant un traitement thermique à l'empilement 211, à une température de séparation supérieure ou égale aux températures du dépôt et de cristallisation de l'étape c). En effet, les microcavités présentes dans le plan fragile enterré 12 suivent une cinétique de croissance jusqu'à l'initiation d'une onde de fracture qui va se propager sur toute l'étendue du plan fragile enterré 12 et provoquer la séparation entre la structure composite 1, et le reste du substrat initial 111'. En pratique, la température pourra être comprise entre 950°C et 1200°C, et préférentiellement entre 1000°C et 1200°C, en fonction des conditions d'implantation de l'étape b).

Selon un mode alternatif de mise en oeuvre, l'étape d) de séparation est opérée par application d'une contrainte mécanique à l'empilement 211, optionnellement précédée d'un traitement thermique de fragilisation du plan fragile enterré 12. La contrainte pourra par exemple être exercée par l'insertion d'un outil (ex : lame de rasoir) à proximité du plan fragile enterré 12. A titre d'exemple, la contrainte de séparation pourra être de l'ordre de quelques Giga-Pascal, préférentiellement supérieure à 2GPa.

Selon un autre mode de réalisation, l'étape d) de séparation peut s'opérer lors du dernier (nième) recuit de cristallisation de l'étape c). Dans un tel cas, on peut éventuellement prévoir de réaliser, après séparation, au moins un (n+1)ième dépôt DLI-CVD pour épaissir davantage le substrat support 20 et un au moins (n+1)ième recuit de cristallisation pour former le p-SiC.

Après l'étape d), on obtient une structure composite 1 comprenant une couche mince 10 en carbure de silicium monocristallin disposée sur un substrat support 20 en carbure de silicium poly-cristallin.

Comme cela est connu en soi, à l'issue de l'étape d) de séparation, la face libre 10a de la couche mince 10 de la structure composite 1 présente une rugosité de surface comprise entre 5 et 100 nm RMS (par mesure au microscope à force atomique (AFM), sur des scans de 20 microns x 20 microns).

Une étape e) de traitement(s) mécanique(s) et/ou chimique(s) de la structure composite 1 peut donc être prévue pour lisser la surface libre 10a de la couche mince 10 et pour corriger l'uniformité d'épaisseur de la structure composite 1 (figure 2e) .

L'étape e) peut comprendre un polissage mécano-chimique (CMP) de la face libre 10a de la couche mince 10, typiquement avec un retrait de matière de l'ordre de 50 nm à 1000 nm, de manière à obtenir une rugosité finale inférieure à 0,5 nm Rms (sur un champ AFM de 20x20pm), voire inférieure à 0,3 nm. L'étape e) peut également comprendre un traitement chimique ou plasma (nettoyage ou gravure), par exemple un nettoyage de type SC1/SC2 (Standard Clean 1, Standard Clean 2) et/ou HF (acide fluorhydrique), ou un plasma N2, Ar, CF4, etc, pour améliorer encore la qualité de la face libre 10a de la couche mince 10.

De plus, l'étape e) peut comprendre un polissage mécano-chimique (CMP) et/ou un traitement chimique (gravure ou nettoyage) et/ou un traitement mécanique (rectification / rodage) de la face arrière 20b du substrat support 20. Cela permet de retirer tout ou partie des fissures 2 résiduelles. Un tel traitement permet également d'améliorer l'uniformité d'épaisseur dudit substrat support 20 ainsi que sa rugosité en face arrière 20b. Une rugosité inférieure à 0,5 nm RMS (par mesure au microscope à force atomique (AFM), sur des champs de 20 microns x 20 microns) est souhaitée pour élaborer des composants verticaux, pour lesquels au moins une électrode métallique sera présente sur la face arrière 20b du substrat composite 1.

Notons que ces traitements appliqués à la face arrière 20b du substrat support 20 pourraient optionnellement être opérés juste avant l'étape d) de séparation, c'est-à-dire avant que la face avant 10a de la structure composite 1 ne soit mise à nu, de manière à limiter sa contamination, notamment au cours de traitements polluants ou contraignants tels que la gravure chimique ou le rodage mécanique (ou rectification mécanique).

On pourra également réaliser, lors de cette étape e), un polissage ou une rectification des bords de la structure composite 1 pour rendre compatible la forme de son contour circulaire et de la tombée de bord avec les exigences des procédés de fabrication microélectroniques.

Selon un mode de réalisation avantageux, l'étape e) de traitement mécano-chimique comprend un polissage (CMP) simultané d'une face avant 10a et d'une face arrière 20b de la structure composite 1, pour lisser et améliorer l'uniformité d'épaisseur de ladite structure 1. Les paramètres de polissage pourront être différents entre la face avant et la face arrière, le lissage d'une surface de c-SiC et d'une surface de p-SiC requérant habituellement des consommables différents. On privilégie en particulier la composante mécanique du polissage pour la face arrière 20b lorsque le substrat support 20 est en p-SiC, pour limiter l'attaque préférentielle des joints de grains par la composante chimique du polissage. Au titre d'exemple, les paramètres de polissage, comme la vitesse de rotation (tête de polissage et plateau), la pression, la concentration et les propriétés physiques des abrasifs (i.e. diamètre de nanoparticules de diamant entre une dizaine de nm et 1µm), peuvent être modifiés pour accentuer la composante mécanique.

Optionnellement, une étape e') de traitement thermique à une température comprise entre 1000°C et 1800°C, pendant environ une heure et jusqu'à quelques heures, est opérée après l'étape e). L'objectif de cette étape est de stabiliser la structure composite 1, en guérissant des défauts structurels ou de surface, encore présents dans et/ou sur la couche mince 10, et en faisant, le cas échéant, évoluer la configuration cristalline du substrat support 20, de sorte que la structure 1 soit compatible avec des traitements thermiques ultérieurs à hautes températures, requis pour la fabrication de composants sur la couche mince 10. Un tel traitement thermique peut également présenter l'avantage de restaurer une bonne conductivité électrique au niveau des interfaces de dépôt des couches ayant formé le substrat support 20.

Le procédé selon l'invention peut comprendre une deuxième étape f) de croissance par épitaxie d'une couche additionnelle 10' de carbure de silicium monocristallin sur la couche mince 10 de la structure composite 1 (figure 2f). Une telle étape est appliquée lorsqu'une épaisseur relativement importante de couche utile 100 est nécessaire pour la fabrication de composants, typiquement, de l'ordre de 5 à 50 microns.

On pourra choisir de limiter les températures appliquées lors de cette étape f), de manière à restreindre les contraintes induites dans la couche utile 100 (correspondant à l'ensemble couche mince 10 et couche additionnelle 10') du fait de la structure composite 1.

Enfin, le procédé de fabrication peut comprendre une étape de reconditionnement du reste 111' du substrat donneur en vue d'une réutilisation en tant que substrat initial 11 ou en tant que substrat donneur 111. Une telle étape de reconditionnement est basée sur un ou plusieurs traitements de la face 110'a (figure 2d), par polissage mécano-chimique de surface ou de bords, et/ou par rectification mécanique, et/ou par gravure chimique sèche ou humide.

Préférentiellement, l'épaisseur de la couche donneuse 110 formée à l'étape a") est définie de sorte que le reste 111' du substrat donneur 111 puisse être réutilisé au moins deux fois en tant que substrat donneur 111.

Préférentiellement, lorsque la couche de conversion 13 est présente, on prendra garde à conserver ladite couche intacte, c'est-à-dire à conserver toujours une part de couche donneuse 10 sur le reste 111' du substrat donneur. Ainsi, lorsque la part de couche donneuse 10 est insuffisante pour l'élaboration d'une structure composite 1, seule l'étape de croissance par épitaxie de couche donneuse 110 est nécessaire et non l'étape préalable de croissance de la couche de conversion 13.

### Exemple :

Selon un exemple non limitatif de mise en oeuvre, le substrat initial 11 fourni à l'étape a') du procédé de fabrication est une plaquette de c-SiC, de polytype 4H, d'orientation 4.0° par rapport à l'axe <11-20> ± 0.5°, de diamètre 150mm et d'épaisseur 350pm.

Une séquence classique de nettoyage de type RCA (Standard Clean 1 + Standard Clean 2), puis Caro (mélange d'acide sulfurique et d'eau oxygénée), puis HF (acide fluorhydrique), est opérée sur le substrat initial 11 préalablement à l'étape a") de croissance épitaxiale de la couche donneuse 110 en c-SiC.

La croissance est réalisée dans une chambre d'épitaxie, à une température de 1650°C, avec des précurseurs tels que le silane (SiH4) et le propane (C3H8) ou l'éthylène (C2H4), générant la couche donneuse 110 en c-SiC de 30 microns d'épaisseur (vitesse de croissance : 10 microns/h). La couche donneuse présente une densité de défauts BPD de l'ordre de 1/cm².

L'implantation d'ions hydrogène est opérée à une énergie de 150 keV et une dose de 6^{E}16 H+/cm², à travers la surface libre de la couche donneuse 110. Un plan fragile enterré 12 est ainsi créé à une profondeur d'environ 800 nm dans le substrat initial 11. Une séquence de nettoyage de type RCA + Caro est opérée sur le substrat donneur 111, de manière à éliminer les potentielles contaminations sur la face libre de la couche donneuse 110.

Un premier dépôt DLI-CVD est effectué sur la couche donneuse 110, à une température de 650°C, avec le précurseur disilanebutane (DSB), sous une pression de 50 Torr, pendant 80 minutes, de manière à atteindre une épaisseur de 140 microns pour la première couche support 20'. Dans ces conditions, ladite couche support 20' forme une matrice SiC amorphe, comprenant des sous-produits de réaction issus des précurseurs de dépôt.

Un premier recuit de cristallisation à 800°C est ensuite appliqué à l'empilement 211 pendant moins de 15 minutes, sous atmosphère neutre azote ou argon. La cristallisation de la première couche support 20' en p-SiC provoque l'apparition de fissures 2.

Un deuxième dépôt DLI-CVD est effectué sur la première couche support cristallisée 20", dans les mêmes conditions que le premier dépôt, de manière à atteindre une épaisseur de 140 microns pour la deuxième couche support 20'. Ce dépôt permet également de combler les fissures superficielles de la première couche support cristallisée 20". La deuxième couche support 20' forme également une matrice SiC au moins partiellement amorphe. Un deuxième recuit de cristallisation similaire au premier recuit est ensuite opéré. La cristallisation de la matrice SiC déposé dans les fissures 2" permet de guérir la première couche support cristallisée 20". La deuxième couche support cristallisée 20" est également formée en p-SiC et des fissures 2 apparaissent dans cette deuxième couche 20".

Un troisième dépôt DLI-CVD est effectué sur la deuxième couche support cristallisée 20", suivi d'un troisième recuit de cristallisation, identiques aux précédents.

Enfin, un quatrième dépôt DLI-CVD est effectué sur la troisième couche support cristallisée 20", suivi un quatrième recuit de cristallisation, également identiques aux précédents. Rappelons que les différents dépôts et recuits de cristallisation peuvent tout à fait être effectués dans des conditions différentes entre eux.

La quatrième couche support cristallisée 20" est formée en p-SiC et des fissures 2 apparaissent dans cette quatrième couche 20" .

Le substrat support 20 formé par la superposition des quatre couches support cristallisées 20" présente une épaisseur de l'ordre de 560 microns.

Un recuit à 1000°C pendant 50 min et ensuite appliqué à l'empilement formé du substrat donneur 111 et du substrat support 20. La séparation s'opère au niveau du plan fragile enterré 12 au cours dudit recuit. A l'issue de cette étape d) de séparation, la structure composite 1 formée de la couche mince 10 et du substrat support 20 est séparée du reste 111' du substrat donneur.

Une rectification de la face arrière du substrat support 20 est effectuée pour éliminer la zone comportant des fissures 2 résiduelles. Pour cela, une épaisseur de l'ordre de 100 à 200 microns est retirée au niveau de la face arrière du substrat support 20.

Un ou plusieurs polissage(s) mécano-chimiques est(sont) ensuite opéré(s) pour restaurer la rugosité de surface de la couche mince 10 et de la face arrière du substrat support 20, suivi (s) de séquences de nettoyage classiques.

Bien entendu, l'invention n'est pas limitée aux modes de réalisation et aux exemples décrits, et on peut y apporter des variantes de réalisation sans sortir du cadre de l'invention tel que défini par les revendications.

## Revendications

1. Procédé de fabrication d'une structure composite (1) comprenant une couche mince (10) en carbure de silicium monocristallin disposée sur un substrat support (20) en carbure de silicium, le procédé comprenant:
**a)** une étape de fourniture d'un substrat donneur (111) en carbure de silicium monocristallin,
**b)** une étape d'implantation ionique d'espèces légères dans le substrat donneur (111), pour former un plan fragile enterré (12) délimitant la couche mince (10) entre ledit plan fragile enterré (12) et une surface libre dudit substrat donneur (111),
**c)** une succession de n étapes de formation de couches supports cristallisées (20"), avec n supérieur ou égal à 2 ; les n couches supports cristallisées (20") étant disposées sur la face avant du substrat donneur (111) successivement les unes sur les autres, et formant le substrat support (20) ; chaque étape de formation comprenant :
- un dépôt chimique en phase vapeur assisté par injection liquide directe, à une température inférieure à 900°C, pour former une couche support (20'), ladite couche support (20') étant formée par une matrice SiC au moins partiellement amorphe, et présentant une épaisseur inférieure ou égale à 200 microns ;
- un traitement thermique de cristallisation de la couche support (20'), à une température inférieure ou égale à 1000°C, pour former une couche support cristallisée (20"),
**d)** une étape de séparation le long du plan fragile enterré (12), pour former d'une part une structure composite (1) comprenant la couche mince (10) sur le substrat support (20), et d'autre part le reste (111') du substrat donneur.

2. Procédé de fabrication selon la revendication précédente, comprenant :
**e)** une étape de traitement(s) mécanique(s) et/ou chimique(s) de la structure composite (1), les traitements étant appliqué(s) à une face libre du substrat support (20), face arrière de la structure composite (1) et/ou à une face libre de la couche mince (10), face avant de la structure composite (1).

3. Procédé de fabrication selon la revendication précédente, dans lequel l'étape e) comprend un polissage mécano-chimique simultané de la face avant et de la face arrière de la structure composite (1).

4. Procédé de fabrication selon l'une des revendications précédentes, dans lequel une gravure chimique, un rodage mécanique et/ou un polissage mécano-chimique est(sont) appliqué(s) à une face libre du substrat support (20), entre l'étape c) et l'étape d).

5. Procédé de fabrication selon l'une des revendications précédentes, dans lequel l'épaisseur de chaque couche support (20') déposée est inférieure ou égale à 100 microns, voire inférieure à 50 microns, voire encore inférieure à 10 microns.

6. Procédé de fabrication selon l'une des revendications précédentes, dans lequel les dépôts de l'étape c) sont effectués à une température comprise entre 100°C et 800°C, voire préférentiellement entre 200°C et 600°C.

7. Procédé de fabrication selon l'une des revendications précédentes, dans lequel les dépôts de l'étape c) sont effectués sous une pression comprise entre 1 Torr et 500 Torr.

8. Procédé de fabrication selon l'une des revendications précédentes, dans lequel les précurseurs, utilisés lors les dépôts de l'étape c), sont choisis parmi le polysilyléthylène et le disilabutane.

9. Procédé de fabrication selon l'une des revendications précédentes, dans lequel l'étape c) comprend une succession de n étapes de formation de couches support cristallisées (20"), avec n compris entre 3 et quelques dizaines.

10. Procédé de fabrication selon l'une des revendications précédentes, dans lequel l'étape a) comprend :
a') une étape de fourniture d'un substrat initial (11) en carbure de silicium monocristallin,
a") une étape de croissance par épitaxie d'une couche donneuse (110) en carbure de silicium monocristallin sur le substrat initial (11), pour former le substrat donneur (111), la couche donneuse (110) présentant une densité de défauts cristallins inférieure à celle du substrat initial (11) .

11. Procédé de fabrication selon la revendication précédente, dans lequel l'étape a') comprend la formation, sur le substrat initial (11), d'une couche monocristalline de conversion (13), pour convertir des défauts de type dislocation du plan basal du substrat initial (11) en défauts de type dislocations coin traversantes.

12. Procédé de fabrication selon l'une des revendications précédentes, dans lequel l'étape a") de croissance par épitaxie est effectuée à une température supérieure à 1200°C, préférentiellement comprise entre 1500°C et 1650°C.

13. Procédé de fabrication selon l'une des revendications précédentes, dans lequel l'étape d) de séparation est opérée à une température supérieure ou égale à la température des traitements thermiques de cristallisation de l'étape c).

14. Procédé de fabrication selon l'une des revendications précédentes, comprenant une étape de reconditionnement du reste (111') du substrat donneur en vue d'une réutilisation en tant que substrat initial ou en tant que substrat donneur.

## Patentansprüche

1. Verfahren zum Herstellen einer Verbundstruktur (1), umfassend eine dünne Schicht (10) aus monokristallinem Siliciumcarbid, die auf einem Trägersubstrat (20) aus Siliciumcarbid angeordnet ist, das Verfahren umfassend:
a) einen Schritt eines Bereitstellens eines Donorsubstrats (111) aus monokristallinem Siliciumcarbid,
b) einen Schritt eines lonenimplantierens von leichten Spezies in das Donorsubstrat (111) zum Ausbilden einer spröden eingegrabenen Ebene (12), die die dünne Schicht (10) zwischen der spröden eingegrabenen Schicht (12) und einer freien Oberfläche des Donorsubstrats (111) begrenzt,
c) eine Folge von n Schritten zur Bildung von kristallisierten Trägerschichten (20"), wobei n größer oder gleich 2 ist; wobei die n kristallisierten Trägerschichten (20") auf der Vorderseite des Donorsubstrats (111) nacheinander übereinander angeordnet sind und die Trägerschicht (20) bilden; wobei jeder Bildungsschritt Folgendes umfasst:
- eine durch direkte flüssige Injektion unterstützte chemische Abscheidung aus der Dampfphase bei einer Temperatur unter 900 °C, um eine Trägerschicht (20') zu bilden, wobei die Trägerschicht (20') durch eine zumindest teilweise amorphe SiC-Matrix gebildet wird und eine Dicke von 200 Mikrometern oder weniger aufweist;
- eine Wärmebehandlung zur Kristallisation der Trägerschicht (20') bei einer Temperatur von 1000 °C oder weniger, um eine kristallisierte Trägerschicht (20") zu bilden,
d) einen Schritt des Trennens entlang der spröden eingegrabenen Ebene (12) zum Ausbilden einerseits einer Verbundstruktur (1), umfassend die dünne Schicht (10) auf dem Trägersubstrat (20), und andererseits des Rests (111') des Donorsubstrats.

2. Verfahren zum Herstellen nach dem vorstehenden Anspruch, umfassend:
e) einen Schritt der mechanischen und/oder chemischen Behandlung(en) der Verbundstruktur (1), wobei die Behandlungen auf eine freie Fläche des Trägersubstrats (20), auf eine Rückfläche der Verbundstruktur (1), und/oder auf eine freie Fläche der dünnen Schicht (10), auf eine Vorderfläche der Verbundstruktur (1), angewendet wird/werden.

3. Herstellungsverfahren nach dem vorstehenden Anspruch, wobei Schritt e) ein gleichzeitiges mechanisch-chemisches Polieren der Vorderfläche und einer Rückfläche der Verbundstruktur (1) umfasst.

4. Herstellungsverfahren nach einem der vorstehenden Ansprüche, wobei ein chemisches Ätzen, ein mechanisches Läppen und/oder ein mechanisch-chemisches Polieren auf eine freie Fläche des Trägersubstrats (20) zwischen Schritt c) und Schritt d) angewendet wird/werden.

5. Herstellungsverfahren nach einem der vorstehenden Ansprüche, bei dem die Dicke jeder aufgebrachten Trägerschicht (20') kleiner oder gleich 100 Mikrometer, sogar kleiner als 50 Mikrometer oder sogar kleiner als 10 Mikrometer ist.

6. Herstellungsverfahren nach einem der vorstehenden Ansprüche, wobei das Abscheiden von Schritt c) bei einer Temperatur zwischen 100 °C und 800 °C, sogar vorteilhafterweise zwischen 200 °C und 600 °C, vorgenommen wird.

7. Herstellungsverfahren nach einem der vorstehenden Ansprüche, wobei das Abscheiden von Schritt c) bei einem Druck zwischen 1 Torr und 500 Torr vorgenommen wird.

8. Herstellungsverfahren nach einem der vorstehenden Ansprüche, wobei die Vorläufer, die bei der Abscheidung von Schritt c) verwendet werden, aus Polysilylethylen und Disilabutan ausgewählt sind.

9. Herstellungsverfahren nach einem der vorstehenden Ansprüche, wobei Schritt c) eine Folge von n Schritten zur Bildung von kristallisierten Trägerschichten (20") umfasst, wobei n zwischen 3 und einigen Dutzend liegt.

10. Herstellungsverfahren nach einem der vorstehenden Ansprüche, wobei der Schritt a) Folgendes umfasst:
a') einen Schritt des Bereitstellens eines ursprünglichen Substrats (11) aus monokristallinem Siliciumcarbid,
a") einen Schritt des Aufwachsens durch Epitaxie einer Donorschicht (110) aus monokristallinem Siliciumcarbid auf dem Anfangssubstrat (11), zum Ausbilden des Donorsubstrats (111), wobei die Donorschicht (110) eine Dichte an Kristalldefekten aufweist, die kleiner als die des Anfangssubstrats (11) ist.

11. Herstellungsverfahren nach dem vorstehenden Anspruch, wobei der Schritt a) das Ausbilden, auf dem Anfangssubstrat (11), einer monokristallinen Umwandlungsschicht (13) zum Umwandeln von Defekten einer Art von Versetzung der Basalebene des Anfangssubstrats (11) in Defekte einer Art von durchgehenden Randversetzungen umfasst.

12. Herstellungsverfahren nach einem der vorstehenden Ansprüche, wobei der Schritt a") des Aufwachsens durch Epitaxie bei einer Temperatur über 1200 °C, vorzugsweise zwischen 1500 °C und 1650 °C, vorgenommen wird.

13. Herstellungsverfahren nach einem der vorstehenden Ansprüche, wobei der Schritt d) des Trennens bei einer Temperatur herbeigeführt wird, die höher als oder gleich der Temperatur der Wärmebehandlungen zur Kristallisation von Schritt c) ist.

14. Herstellungsverfahren nach einem der vorstehenden Ansprüche, umfassend einen Schritt des Wiederaufbereitens des Rests (111') des Donorsubstrats im Hinblick auf eine Wiederverwendung in der Eigenschaft als Anfangssubstrat oder in der Eigenschaft als Donorsubstrat.

## Claims

1. Method for producing a composite structure (1) comprising a thin layer (10) which is made of monocrystalline silicon carbide and arranged on a support substrate (20) made of silicon carbide, the method comprising:
a) a step of providing a donor substrate (111) made of monocrystalline silicon carbide,
b) a step of implanting ions of light species into the donor substrate (111) to form a buried brittle plane (12) which delimits the thin layer (10) between the buried brittle plane (12) and a free surface of the donor substrate (111),
c) a succession of n steps of forming crystallized support layers (20"), with n being greater than or equal to 2; the n crystallized support layers (20") being arranged on the front face of the donor substrate (111) successively one on top of the other, and forming the support substrate (20); each forming step comprising:
- chemical vapor deposition assisted by direct liquid injection, at a temperature of less than 900°C, to form a support layer (20'), said support layer (20') being formed by an at least partially amorphous SiC matrix, and having a thickness less than or equal to 200 microns;
- a heat treatment for crystallizing the support layer (20'), at a temperature less than or equal to 1000°C, to form a crystallized support layer (20"),
d) a step of separating along the buried brittle plane (12) to form a composite structure (1) which comprises the thin layer (10) on the support substrate (20) on one side and the remainder (111') of the donor substrate on the other.

2. Production method according to the preceding claim, comprising:
e) a step of mechanically and/or chemically treating the composite structure (1), the treatments being applied to a free face of the support substrate (20), the rear face of the composite structure (1), and/or to a free face of the thin layer (10), the front face of the composite structure (1).

3. Production method according to the preceding claim, wherein step e) comprises simultaneous chemical-mechanical polishing of the front face and the rear face of the composite structure (1).

4. Production method according to any of the preceding claims, wherein chemical etching, mechanical grinding and/or chemical-mechanical polishing is/are applied to a free face of the support substrate (20) between step c) and step d).

5. Production method according to any of the preceding claims, wherein the thickness of each deposited support layer (20') is less than or equal to 100 microns, or less than 50 microns, or even less than 10 microns.

6. Production method according to any of the preceding claims, wherein the depositions of step c) are carried out at a temperature of between 100°C and 800°C, or preferably between 200°C and 600°C.

7. Production method according to any of the preceding claims, wherein the depositions of step c) are carried out under a pressure of between 1 Torr and 500 Torr.

8. Production method according to any of the preceding claims, wherein the precursors used during the depositions of step c) are selected from polysilylethylene and disilabutane.

9. Production method according to any of the preceding claims, wherein step c) comprises a succession of n steps of forming crystallized support layers (20"), with n being between 3 and a few tens.

10. Production method according to any of the preceding claims, wherein step a) comprises:
a') a step of providing an initial substrate (11) made of monocrystalline silicon carbide,
a") a step of epitaxially growing a donor layer (110) made of monocrystalline silicon carbide on the initial substrate (11) to form the donor substrate (111), the donor layer (110) having a density of crystalline defects of less than that of the initial substrate (11).

11. Production method according to the preceding claim, wherein step a') comprises forming, on the initial substrate (11), a monocrystalline conversion layer (13) to convert dislocation defects of the basal plane of the initial substrate (11) into through-corner dislocation defects.

12. Production method according to any of the preceding claims, wherein the epitaxial growth step a") is carried out at a temperature of greater than 1200°C, preferably between 1500°C and 1650°C.

13. Production method according to any of the preceding claims, wherein the separation step d) is performed at a temperature which is greater than or equal to the temperature of the crystallization heat treatments of step c).

14. Production method according to any of the preceding claims, comprising a step of reconditioning the remainder (111') of the donor substrate for reuse as an initial substrate or as a donor substrate.
